# EUROPEAN PATENT SPECIFICATION

(11) **EP 1 425 593 B1**
(45) Date of publication and mention of the grant of the patent: **15.11.2006**
(21) Application number: 02798941.7
(22) Date of filing: 09.09.2002
(51) Int. Cl.: G01R 31/319

(54) **BUILT-IN SELF-TESTING OF MULTILEVEL SIGNAL INTERFACES**
EINGEBAUTE SELBSTPRÜFUNG VON MEHRPEGELSIGNALSCHNITTSTELLEN
AUTO-TEST INTEGRE D'INTERFACES DE SIGNAUX MULTINIVEAUX

(30) Priority: 14.09.2001 US 953514; 14.09.2001 US 953486
(43) Date of publication of application: 09.06.2004
(73) Proprietor: RAMBUS INC., Los Altos, California 94022 (US)
(72) Inventor: WERNER, Carl, W., Los Gatos, CA 95032 (US); ZERBE, Jared, L., Woodside, CA 94062 (US); STONECYPHER, William, F., San Jose, CA 95118 (US)
(74) Representative: Eisenführ, Speiser & Partner
(86) International application number: PCT/US2002/028629
(87) International publication number: WO 2003/025599

(56) References cited:
- GB-A- 1 533 576
- US-A- 5 097 144
- US-A- 5 453 990
- US-A- 6 154 074
- US-B1- 6 230 221

## Description

### BACKGROUND OF THE INVENTION

The present invention relates to multilevel digital signaling, and in particular to mechanisms to test for errors that may occur in a multilevel, multi-line signaling system.

The use of multiple signal levels instead of binary signal levels is a known technique for increasing the data rate of a digital signaling system, without necessarily increasing the signal frequency of the system. Such multilevel signaling is sometimes known as multiple pulse amplitude modulation or multi-PAM, and has been implemented with radio or other long-distance wireless signaling systems.

Other long-distance uses for multi-PAM signaling include computer or telecommunication systems that employ Gigabit Ethernet over optical fiber (IEEE 802.3z) and over copper wires (IEEE 802.3ab), which use three and five signal levels, respectively, spaced symmetrically about and including ground.

Multi-PAM has not traditionally been used for communication between devices in close proximity or belonging to the same system, such as those connected to the same integrated circuit (IC) or printed circuit board (PCB). One reason for this may be that within such a system the characteristics of transmission lines, such as buses or signal lines, over which signals travel are tightly controlled, so that increases in data rate may be achieved by simply increasing data frequency. At higher frequencies, however, receiving devices may have a reduced ability to distinguish binary signals, so that dividing signals into smaller levels for multi-PAM is problematic. Multi-PAM may also be more difficult to implement in multi-drop bus systems (i.e., buses shared by multiple processing mechanisms), since the lower signal-to-noise ratio for such systems sometimes results in bit errors even for binary signals.

Testing of a multi-PAM device is also problematic, since test apparatuses are typically designed for testing binary signals. Thus, in addition to the complexities of designing a multi-PAM device, conventional ways of testing a multi-PAM device to ensure that the device operates free of errors may be lacking.

US Patent 5,097,144 relates to a driver circuit for use in testing binary bidirectional semiconductor devices. The DUT (Device Under Test) is a conventional binary device having only two signal levels (high and low). A signal having three states (high, low, middle) is used for test purposes of the conventional I/O port for efficient testing.

US Patent 6,230,221 B1 discloses to a host system where a host computer is coupled to a bank of disk drives. The signal interfaces are based on conventional two-level binary representation.

The UK Patent 1 533 576 relates to a device where a plurality of master and slave devices are efficiently coupled to one another. The signal interfaces are based on conventional two-level binary representation.

### SUMMARY

Error detection mechanisms for signal interfaces are disclosed, including built-in self-test (BIST) mechanisms for testing multilevel signal interfaces. The error detection mechanisms may be provided in an integrated circuit (IC) chip that contains at least one of the signal interfaces, or may be coupled to the interfaces on a printed circuit board (PCB). BIST mechanisms may include, for example, test signal generators and mechanisms for determining whether the test signals generated are accurately transmitted and received by the interface. The BIST mechanisms may check a single input/output interface, a group of interfaces or may operate with a master device that tests a plurality of slave device interfaces. The error detection mechanisms may be particularly advantageous for testing memory circuits designed to communicate according to multi-PAM signals over printed circuit boards.

### BRIEF DESCRIPTION OF THE FIGURES

FIG. 1 is a diagram of a multilevel signaling system having four logical states corresponding to four voltage ranges.
FIG. 2 is a diagram of a representative multilevel signaling device that may be used to create the voltage levels of FIG. 1.
FIG. 3 is a diagram of a differential 4-PAM signaling system.
FIG. 4A is a diagram of a pair of encoders translating binary signals into multiplexed control signals for the multilevel signaling device of FIG. 2.
FIG. 4B is a diagram of one of the encoders of FIG. 4A that encodes MSB even and LSB even signals into control signals.
FIG. 5A is a diagram of a receiver and decoder that receives the multilevel signals sent by the signaling device of FIG. 2 and decodes the signals into binary MSB even and LSB even components.
FIG. 5B is a diagram of the receiver and decoder of FIG. 5A along with another receiver and decoder that receive the multilevel signals sent by the signaling device of FIG. 2 and decode the signals into binary MSB and LSB even and odd components.
FIG. 6 is a diagram of a device including a multilevel signal interface coupled to a memory, sequence generators and an error detector.
FIG. 7 is a diagram of a system including a multilevel signal interface having a plurality of interface units that are connectable in series for testing.
FIG. 8 is a diagram of a system including a signal interface grouped into plural bytes of multilevel signal interface units and a byte of binary signal interface units, with each of the multilevel signal interface units in a first byte being connectable to a corresponding multilevel signal interface unit in a second byte for testing.
FIG. 9A is a diagram of a set of four pseudo-random bit sequence generators that can generate signals for testing the system of FIG. 8.
FIG. 9B is a diagram of a single pseudo-random bit sequence generator that can generate a set of four signals for testing the system of FIG. 8.
FIG. 10 is a functional block diagram of a system including plural devices and a controller each having signal interface units that are connected to a bus, with the controller serving as a master and the devices acting as slaves for testing.
FIG. 11 is a perspective view of the system of FIG. 10 affixed to a printed circuit board (PCB) by being removably inserted into the connectors such as slots.
FIG. 12 is a perspective view of the system of FIG. 10 affixed to a PCB without connectors.

### DETAILED DESCRIPTION OF THE PREFERRED EMBODIMENT

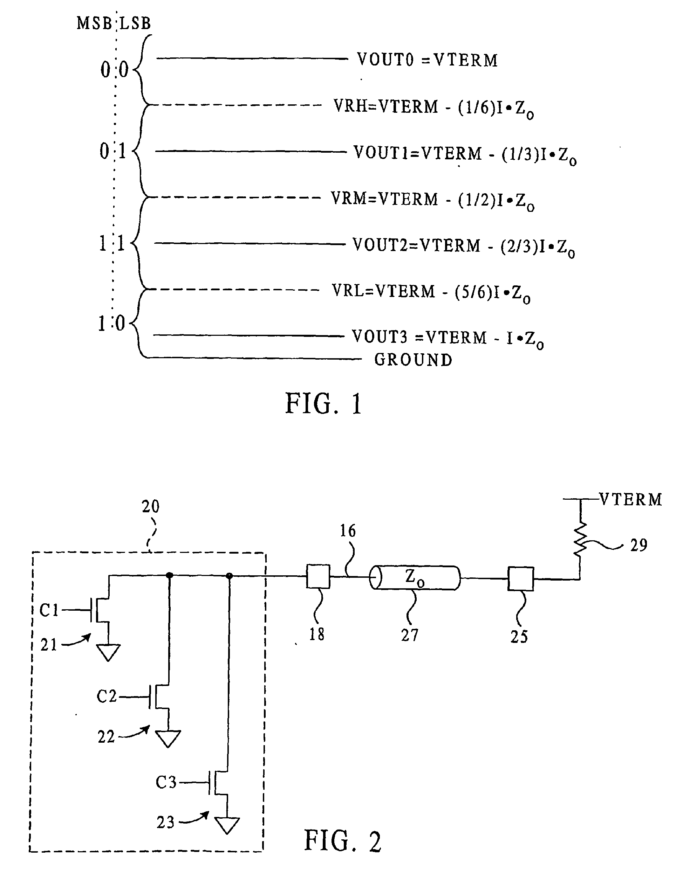

FIG. 1 shows a multilevel signal system having four logical states corresponding to four distinct voltage levels, VOUT0, VOUT1, VOUT2 and VOUT3. The voltage levels in this example are all positive relative to ground, and range as high as VTERM. VOUT0 is defined to be above VREFH, VOUT1 is defined to be between VREFM and VREFH, VOUT2 is defined to be between VREFL and VREFM, and VOUT3 is defined to be less than VREFL. VOUT0 corresponds to logical state 00, VOUT1 corresponds to logical state 01, VOUT2 corresponds to logical state 11, and VOUT3 corresponds to logical state 10. An example of the 4-PAM system described above has been implemented for a memory system interface having VOUTO=1.80V, VOUT1=1.533V, VOUT2=1.266V and VOUT3=1.00V. Although four logical states are illustrated in this example, a multilevel signal system may have more or less logical states, with at least two reference levels serving as boundaries between the states.

A first bit of each logical state is termed the most significant bit (MSB) and a second bit of each logical state is termed the least significant bit (LSB). Each logical state may be termed a symbol, since it provides information regarding more than one bit. Data may be transmitted and read at both rising and falling edge of a clock cycle, so that each bit signal and each dual-bit signal has a duration of one-half the clock cycle. The logical states are arranged in a Gray coded order, so that an erroneous reading of an adjacent logic state produces an error in only one of the bits. Another characteristic of this logical 4-PAM arrangement is that setting the LSB equal to zero for all states results in a 2-PAM scheme. Alternatively, the logical states can be arranged in numerical (00, 01, 10, 11) or other order.

In one embodiment the communication system is employed for a memory bus that may for instance include random access memory (RAM), like that disclosed in U.S. Patent Number 5,243,703 to Farmwald et al.. The multi-PAM communication and testing techniques disclosed herein may also be used for other contained systems, such as for communication between processors of a multiprocessor apparatus, or between a processor and a peripheral device, such as a disk drive controller or network interface card over an input/output bus.

FIG. 2 shows a representation of a communication system that may be used to create the voltage levels of FIG. 1. An output driver 20 drives signals to output pad 18 and over a signal pathway such as transmission line 16, which may for example be a memory bus or other interconnection between devices affixed to a circuit board; to be received at pad 25. Transmission line 16 has a characteristic impedance Z₀ 27 that is substantially matched with a terminating resistor 29 to minimize reflections.

Output driver 20 includes first 21, second 22 and third 23 transistor current sources, which together produce a current I when all are active, pulling the voltage at pad 25 down from VTERM by I·Z₀, signaling logical state 10 under the Gray code system. Control signal input through lines C1, C2 and C3 switch respective current sources 21, 22 and 23 on and off. To produce voltage VOUT0=VTERM, signaling logical state 00, current sources 21, 22 and 23 are all turned off. To produce voltage VOUT1=VTERM-(1/3)I·Z₀, signaling logical state 01, one of the current sources is turned on; and to produce voltage VOUT2=VTERM-(2/3)I·Z₀, two of the current sources are turned on. The logical level 00 is chosen to have zero current flow to reduce power consumption for the situation in which much of the data transmitted has a MSB and LSB of zero. The reference levels are set halfway between the signal levels, so that VREFH=VTERM-(1/6) I·Z₀, VREFM=VTERM-(1/2) I·Z₀ and VREXFL=VTERM(5/6) I·Z₀.

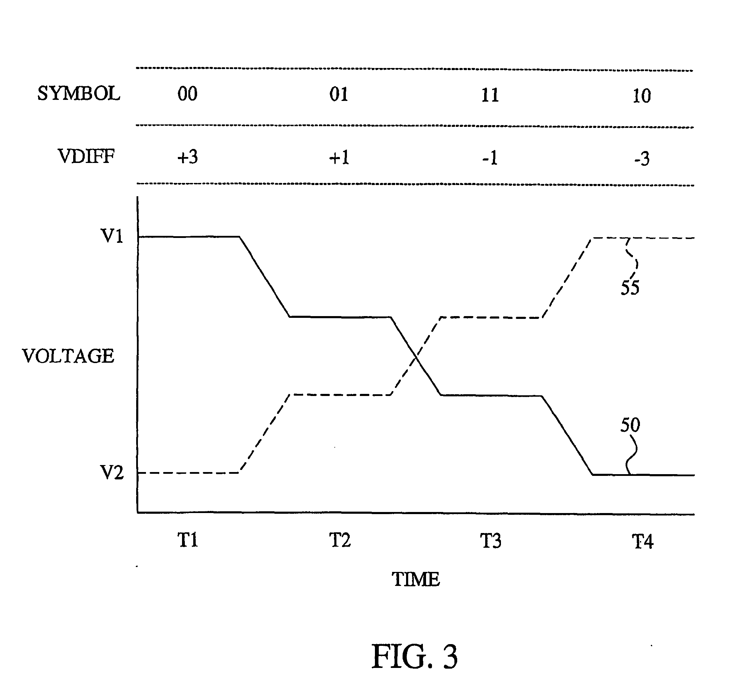

FIG. 3 shows an example of a differential 4-PAM signaling system where data is encoded on two wires or other transmission media and a symbol value is determined by the voltage difference as measured by a receiver. The use of differential signaling can provide increased immunity to noise and crosstalk. A voltage V1 on one of the wires varies over time between four voltage levels, as shown with solid line 50, while a voltage V2 on the other wire also varies between the four voltage levels but in a complementary fashion, as shown with broken line 55. Voltage differences VDIFF between voltages V1 and V2 for times T1, T2, T3 and T4 are listed above the signals in arbitrary units as +3, +1, -1 and -3, respectively. The MSB and LSB symbols corresponding to the voltage differences are listed above the signals in Gray coded sequence.

Another example of a multilevel signaling apparatus and method is disclosed in U.S: Patent Number 6,005,895 to Perino et al.. This and other types of multilevel signal interfaces may also be tested in accordance with the present invention. U.S. Patent application with the publication member 20030093913 discloses other means for testing multilevel signal interfaces; entitled "Multilevel Signal Interface Testing with Binary Test Apparatus by Emulation of Multilevel Signals," filed on the same date as the present application by inventors Werner, Zerbe, Stonecypher, Liaw and Chang.

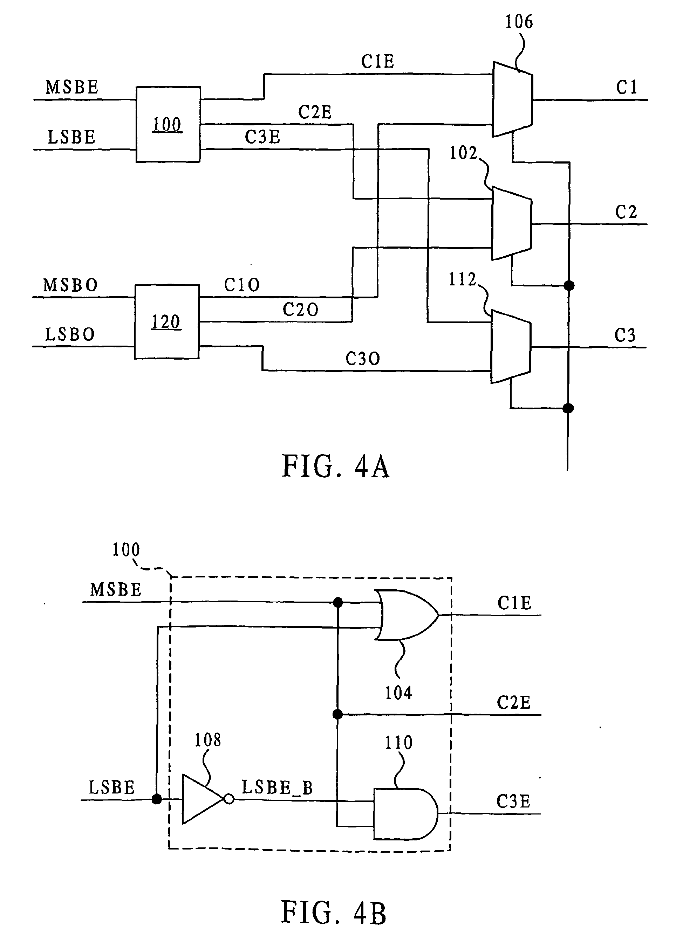

FIG. 4A shows an embodiment for which data is transmitted and read at both rising and falling clock edges, using a pair of substantially identical encoders 100 and 120 translating MSB and LSB odd and even signals into the control signals on lines C1, C2 and C3 for output driver 20. MSB even and LSB even signals on lines MSBE and LSBE are input to encoder 100, which outputs thermometer code signals on lines C1E, C2E and C3E. Similarly, and MSB odd and LSB odd signals on lines MSBO and LSBO are input to encoder 120, which outputs thermometer code signals on lines C1O, C2O and C3O. Lines C1E and C1O input to multiplexer 106, lines C2E and C2O input to multiplexer 102, and lines C3E and C3O input to multiplexer 112. Multiplexers 102, 106 and 112 select the odd or even signals according to a clock select signal on select line 118, outputting the thermometer code control signals on lines C1, C2 and C3.

Encoder 100 is shown in more detail in FIG. 4B. MSBE is connected to line C2E MSBE is also input to an OR gate 104 that has LSBE as its other input, with the output of OR gate 104 connected to line C1E. Signals on line LSBE pass through inverter 108, with the inverted signals on line LSBE_B input to AND gate 110. AND gate 110 receives as its other input line MSBE, with its output connected to line C3E providing a third control signal.

Table 1 illustrates the correspondence between MSB and LSB signals and the control signals on lines C1, C2 and C3 that translate binary signals into 4-PAM signals.

**Table 1**

| MSB | LSB | C1 | C2 | C3 |
|---|---|---|---|---|
| 0 | 0 | 0 | 0 | 0 |
| 0 | 1 | 1 | 0 | 0 |
| 1 | 1 | 1 | 1 | 0 |
| 1 | 0 | 1 | 1 | 1 |

For example, when MSB=0 and LSB=0, all the control signals are off. When MSB=0 and LSB=1, the OR gate 104 outputs on, so that the control signal on line C1 is on, but control signals on lines C2 and C3 are still off. When both MSB=1 and LSB=1, control signals on lines C1 and C2 are on, but due to inverted LSB signals input to AND gates such as AND gate 110, the control signal on line C3 is off. When MSB=1 and LSB=0, control signals on all the lines C1, C2 and C3 are turned on. In this fashion the MSB and LSB may be combined as Gray code and translated to thermometer code control signals on lines C1, C2 and C3 that control the current sources to drive 4-PAM signals.

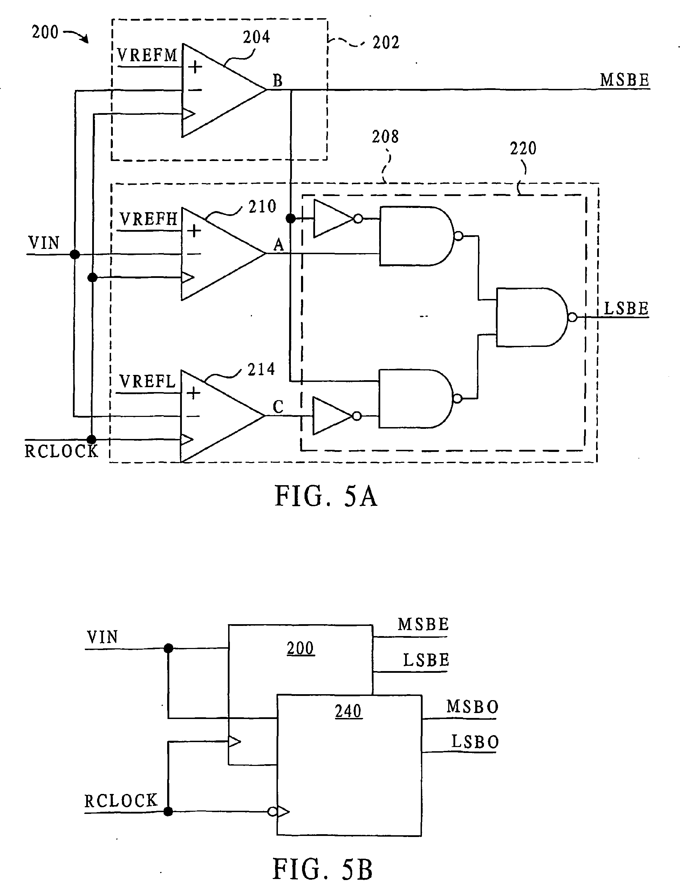

FIG. 5A shows one possible embodiment of a receiver 200 that may be used to receive the multilevel signals sent by drivers such as those described above, and decode the signals into MSBE and LSBE components. As mentioned above, the data may be transmitted at twice the clock frequency, and a substantially identical receiver 240 is shown in FIG. 5B, with receivers 200 and 240 reading even and odd data, respectively.

An MSBE receiver 202 of the 4-PAM receiver 200 in this example receives and decodes a 4-PAM input signal VIN by determining whether the signal VIN is greater or less than VREFM. In the MSBE receiver 202, a latching comparator 204 compares the value of the voltage of the received input signal VIN to the reference voltage VREFM and latches the value of the result of the comparison B in response to a receive clock signal RCLOCK. Although this embodiment discloses data sampling at both rising and falling clock edges, data may alternatively be sampled at only the rising clock edges or only the falling clock edges.

In an LSBE receiver 208, two latching comparators 210 and 214 compare the value of the voltage of the received input signal VIN to the reference voltages VREFH and VREFL, and latch the value of the result of the comparison A and C, respectively, in response to the receive clock signal. To decode the LSBE, the signals from the comparator outputs B, A, and C are then passed through combinational logic 220. The latching comparators 204, 210 and 214 may be implemented as integrating receivers to reduce the sensitivity of the output signals to noise. This can be accomplished by integrating the difference between the received signal, Vin, and the three respective reference voltages over most or all of the bit cycle, and then latching the integrated results as the outputs A, B and C. Related disclosure of a multi-PAM signaling system can be found in U.S. Patent Application Serial Number 09/478,916, publication member 20040235510 entitled "Low Latency Multi-Level Communication Interface," filed on January 6, 2000.

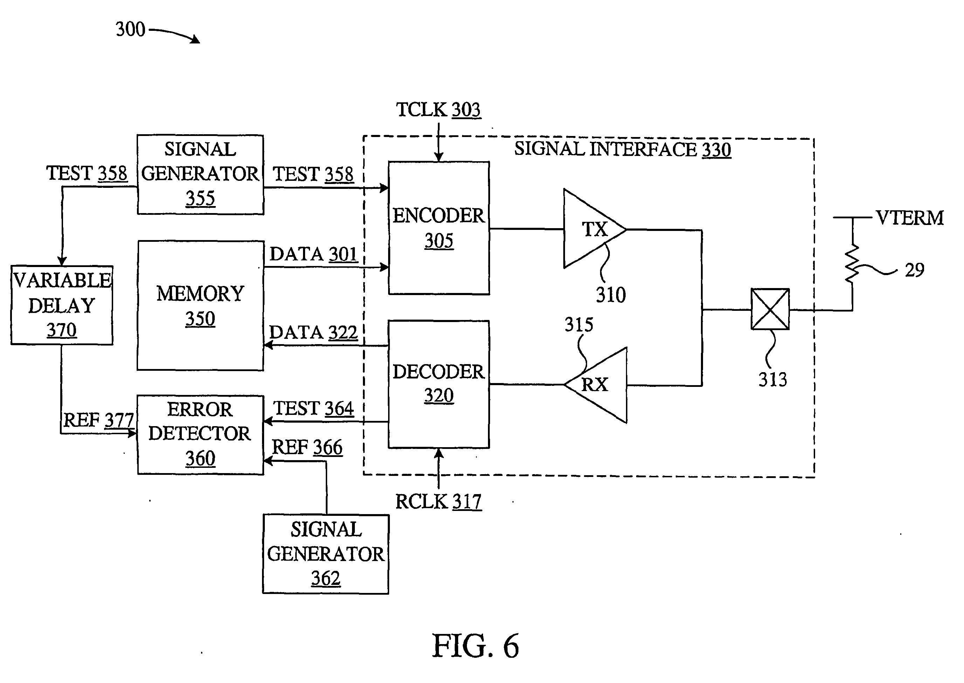

FIG. 6 shows a functional block diagram of one type of device 300 including a multilevel signal interface 330 coupled to an optional 350, both of which may be tested in accordance with the present invention. Memory 350 may store data in binary or other form using semiconductor, magnetic, optical, ferroelectric or other known means for storage. Data signals 301 from memory 350 are clocked with transmit clock signals 303 and encoded at encoder 305, which provides control signals that drive output driver or transmitter 310. Multilevel signals are transmitted by transmitter 310 to input/output pin 313, which affords communication between device 300 and other devices, not shown in this figure.

Encoder 305 and transmitter 310, which together function as a transmit mechanism, may be similar to encoder 100 and output driver 20 described previously, and input/output pin 313 may be similar to pads 18 or 25 described above, for example. Also coupled to input/output pin 313 is receiver 315, which is adapted to detect multilevel signals from pin 313. The output of receiver 315 is sampled with receive clock signals 317 and decoded into binary signals at decoder 320 to be communicated as data 322 for storage in memory 350. Receiver 315 and decoder 320 may be similar to receive mechanism 200 described previously.

To use device 300 for data storage, multilevel signals may be received at I/O pin 313 from a device external to this figure, such as a transmitter or processor connected to pin 313 by a signal pathway such as a conductive line. Those multilevel signals may be detected by receiver 315, translated to binary signals by decoder 320, and sent as data 322 for storage in memory 350. To read information from memory 350, data 301 is sent to encoder 305, which causes transmitter 310 to send multilevel signals to I/O pin 313 for transmission to the external device.

In addition to the data storage mechanisms described above, device 300 includes a signal generator 355 that creates test signals 358 for testing signal interface 330. Signal generator 355 may, for example, include a linear feedback shift register (LFSR) that generates a predictable series of test signals 358, or may include another known pseudo-random bit sequence (PRBS) generator. As an alternative example, signal generator 355 may be programmed to output a known sequence of signals designed to test worst case transitions of the interface 330 or memory 350.

In a test mode, test signals 358 from signal generator 355 may be fed to encoder 305, which causes multilevel signals to be sent by transmitter 310. In contrast with conventional operation, receiver 315 is enabled to detect the multilevel signals and provide them to decoder 320. Decoder 320 translates the multilevel signals to binary test signals 364 that are output to an error detector 360, which determines whether test signals 358 have been accurately transmitted by signal interface 330. Error detector 360 may include a comparison mechanism such as one or more comparitors or other logic elements.

To make this determination, device 300 may include a second signal generator 362 that creates a series of reference signals 366 for comparison with test signals 364. Signal generator 362 may be substantially identical to signal generator 355, e.g., both may be a LFSR having an identical number of bits. To synchronize signal generator 362 with signal generator 355 in this case, an initial set of test signals 364 may be loaded into the shift register of signal generator 362. Alternatively, signal generator 355 may be connected to a variable delay element 370 that delays test signals 358 by an amount substantially equal to the delay of signal interface 330, to provide reference signals 377 to error detector 360, for comparison with test signals 364. Variable delay element 370 may include a plurality of essentially static delay elements, such as flip-flops, as well as a tunable delay element, to form a kind of phase-locked loop (PLL) or delay-locked loop (DLL).

Delay element 370 may also be offset from its ideal timing so that the timing margin may be determined for either transmitting or receiving data. Likewise, each of the reference voltages in Fig 4A may be varied to determined voltage margins for multi-PAM data.

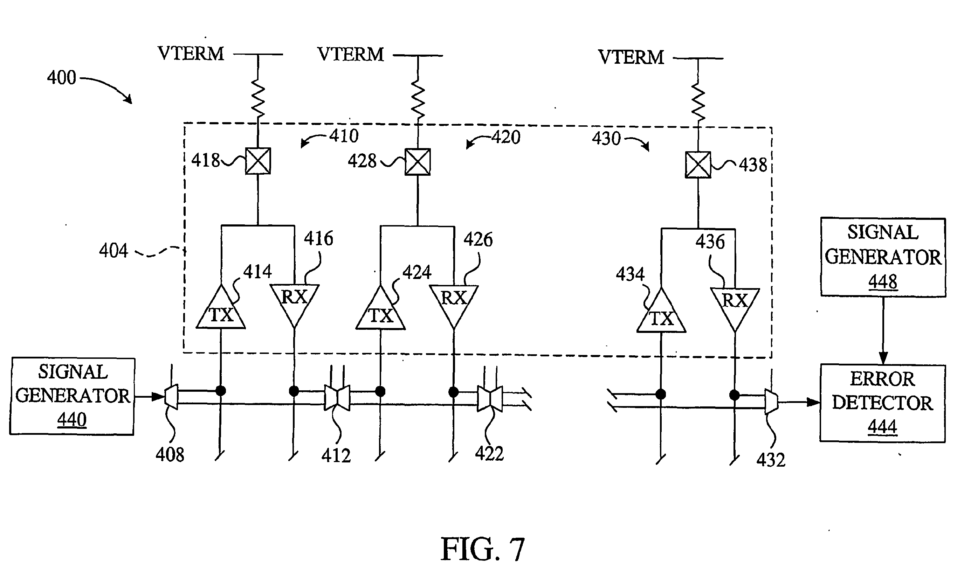

FIG. 7 illustrates a system 400 including a multilevel signal interface 404 having a plurality of signal interface units (410, 420, 430) that are connectable in series for testing, although during operation the signal interface units are arranged to communicate separately or in parallel. That is, during testing the signal interface units are 410, 420 and 430 are enabled for self-testing as described above with reference to FIG. 6, and adjacent signal interface units are also connected to forward test signals from one signal interface unit to the next. During operation, however, signal interface units 410, 420 and 430 separately or in parallel communicate with outside entities via respective I/O pins 418, 428 and 438.

A first signal interface unit 410 includes a first transmit mechanism 414, a first receive mechanism 416 and a first I/O pin 418. A second signal interface unit 420, which includes a second transmit mechanism 424, a second receive mechanism 426 and a second I/O pin 428, is coupled to first signal interface unit 410 via an optional first multiplexer-demultiplexer 412. First multiplexer-demultiplexer 412 can select to bypass second signal interface unit 420 by connecting instead to an optional second multiplexer-demultiplexer 422. Second multiplexer-demultiplexer 412 selects whether second signal interface unit 420 communicates with or bypass a third signal interface unit, not shown.

In this manner N signal interface units may be daisy-chained for testing, with an Nth signal interface unit 430 including an Nth transmit mechanism 434, an Nth receive mechanism 436 and an Nth I/O pin 438, the Nth signal interface unit 430 coupled to the other signal interface units with another multiplexer-demultiplexer, not shown. Each transmit mechanism and each receive mechanism times the signals with clock signals, which may be sent from a master clock generator, not shown in this figure. A first signal generator 440 is coupled to the first signal interface unit 410 via an optional demultiplexer 408, which can be switched to instead bypass first signal interface unit 410. An error detector 444 is coupled to the Nth interface unit 430 and a second signal generator 448 is coupled to the error detector 444.

To test the signal interface 404, signal generator 440 sends a test signal or series of test signals to first transmit mechanism 414, which in turn sends test signals to first receive mechanism 416, in a fashion similar to that described above with regard to FIG. 6. Multiplexer-demultiplexer 412 can be set to send the signals from first receive mechanism 416 to second transmit mechanism 424, which in turn drives signals that are detected by second receive mechanism 426. The signals are thus forwarded to Nth receiver 436, which outputs signals that are detected by error detector 444. An optional multiplexer 432 can select instead to provide signals to error detector 444 that bypass Nth interface unit 430.

Error detector 444 also receives signals from a second signal generator 448, which are compared with the signals from Nth receiver 436 that are detected by error detector 444. The signals from second signal generator 448 are designed to be substantially identical to the test signals output by first signal generator 440 but delayed by a time period substantially equal to the delay encountered in passing through the series of interface units of the signal interface 404. If the signal or series of signals received by error detector 444 from Nth receiver 436 do not match the signal or series of signals received by error detector 444 from second signal generator 448, then error detector 444 outputs an error signal.

A system such as that shown in FIG. 7 has an advantage of being able to test plural interface units with only one or two signal generators. Such testing of multiple interface units can save time for the situation in which errors are not common. In one exemplary embodiment, system 400 may include eight or nine interface units, so that a byte of information may be communicated in parallel through I/O pins 418, 428 and 438 at any given time. For an IC that includes testing means along with a signal interface, such as that shown in FIG. 7, reducing the number of signal generators per interface unit reduces the chip real estate that is devoted to testing.

If an error is found in the signal interface 400, the multiplexers and demultiplexers, or similar logic circuits that select between two inputs and two outputs, can be set to test the individual interface units until the defective unit or units are identified. Alternatively, the individual interface units may be tested initially for errors, or a subset of the interface units may be tested, by appropriate settings of the multiplexers and demultiplexers. In this manner the multiplexers and demultiplexers allow any subset of the N signal interface units to be tested.

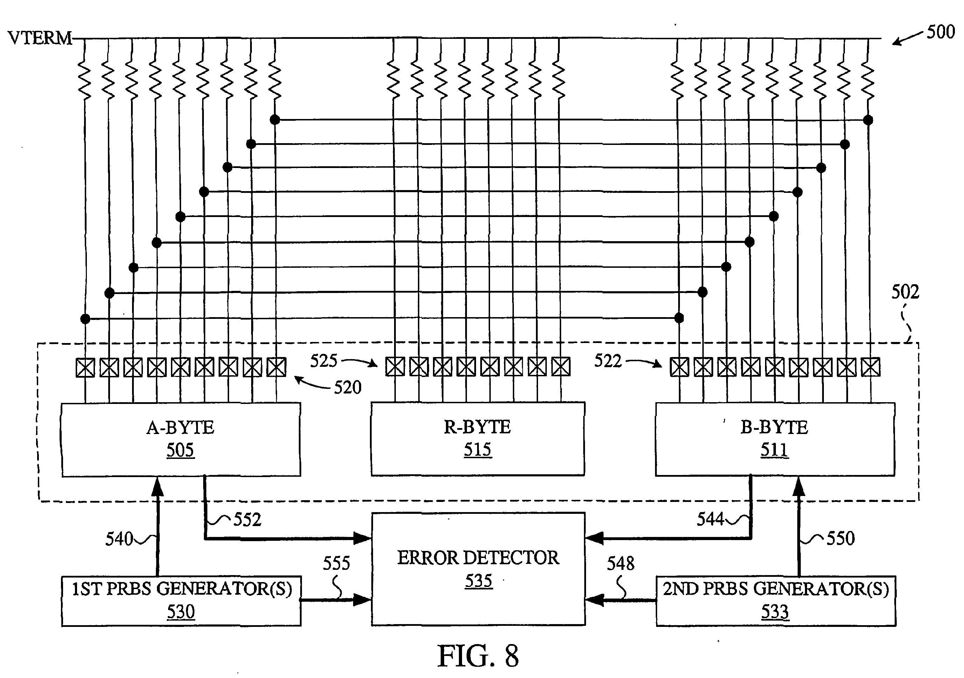

FIG. 8 shows a system 500 including a multilevel signal interface 502 having multiple interface units arranged to facilitate communicating bytes of information. The interface units are grouped into two data communication bytes, A-BYTE 505 and B-BYTE 511, which each include nine multilevel signal interface units in one embodiment, and a control or request byte R-BYTE 515, which includes eight binary signal interface units in this embodiment. The interface units in A-BYTE 505 and B-BYTE 511 may be similar to the multilevel interface units described above, each interface unit having a mechanism for transmitting and receiving multilevel signals, with one of the interface units in both A-BYTE 505 and B-BYTE 511 used for parity signaling. A memory chip or controller, for example, may have one or more interfaces such as interface 502. Provided that termination and DC loading requirements are met, then A-BYTE 505 may be connected to a plurality of bytes such as B-BYTE 511, and any two such bytes could test each other.

Each interface unit of A-BYTE 505 includes an I/O pin in a group of I/O pins labeled 520. Each interface unit of B-BYTE 511 and each interface unit in R-BYTE 515 also includes an I/O pin, disposed in a group of I/O pins labeled 522 and 525, respectively. Each interface unit in A-BYTE 505 is also coupled by a signal pathway to a corresponding interface unit in B-BYTE 511, allowing the A-BYTE 505 to test the B-BYTE 511 and vice-versa.

A first PRBS generator or plurality of PRBS generators 530 may be coupled to the various interface units of A-BYTE 505, and a second PRBS generator or plurality of PRBS generators 533 may be coupled to the various interface units of B-BYTE 511. For the case in which first PRBS generator(s) 530 includes a plurality of different PRBS generators, each of those PRBS generators may be connectable to one or more of the interface units of A-BYTE 505. Similarly, for the case in which second PRBS generator 533 includes a plurality of different PRBS generators, each of those PRBS generators may be connectable to one or more of the interface units of B-BYTE 511. An error detector 535 is coupled to first and second PRBS generator(s) 530 and 533.

To test the interface units in A-BYTE 505 and B-BYTE 511, first PRBS generator(s) 530 may output binary test signals to one or more of the interface units of A-BYTE 505, as shown by arrow 540. Each of the interface units of A-BYTE 505 that receives test signals from first PRBS generator(s) 530 sends multilevel signals to its corresponding interface unit in B-BYTE 511. The multilevel signals are detected by the corresponding interface unit in B-BYTE 511 and decoded to binary signals that are provided to error detector 535, as shown by arrow 544. Reference signals are sent from second PRBS generator(s) 533 to error detector 535, as shown by arrow 548, the reference signals synchronized with the decoded signals. The decoded signals from B-BYTE 511 are compared at error detector 535 with the synchronized reference signals from second PRBS generator(s) 533. Error detector 535 outputs an error signal if the decoded and reference signals being compared do not match, indicating that the transmit mechanism of A-BYTE 505 and/or the receive mechanism of B-BYTE 511 did not function properly.

Similarly, second PRBS generator(s) 533 may output binary test signals to one or more of the interface units of B-BYTE 511, as shown by arrow 550. Each of the interface units of B-BYTE 511 that receives test signals from second PRBS generator(s) 533 sends multilevel signals to its corresponding interface unit in A-BYTE 505. The multilevel signals are detected by the corresponding interface unit in A-BYTE 505 and decoded to binary signals that are provided to error detector 535, as shown by arrow 552. Reference signals are sent from first PRBS generator(s) 530 to error detector 535, as shown by arrow 555, the reference signals synchronized with the decoded signals. The decoded signals from A-BYTE 505 are compared at error detector 535 with the synchronized reference signals from first PRBS generator(s) 530. Error detector 535 outputs an error signal if the decoded and reference signals being compared do not match, indicating that the transmit mechanism of B-BYTE 511 and/or the receive mechanism of A-BYTE 505 did not function properly.

If the system 500 has less PRBS generators than interface units, the testing process may be repeated until all of the interface units have been tested. First PRBS generator(s) 530, or other PRBS generator(s), may be connected to R-Byte 515, and each of the interface units of R-Byte 515 of may be coupled to another of the interface units of R-Byte 515, allowing those interface units to test each other by comparing signals transmitted and received at the error detector 535. Thus, testing of the multilevel signal interface can be accomplished by the means described above, without the need for additional test mechanisms to generate or detect multilevel signals.

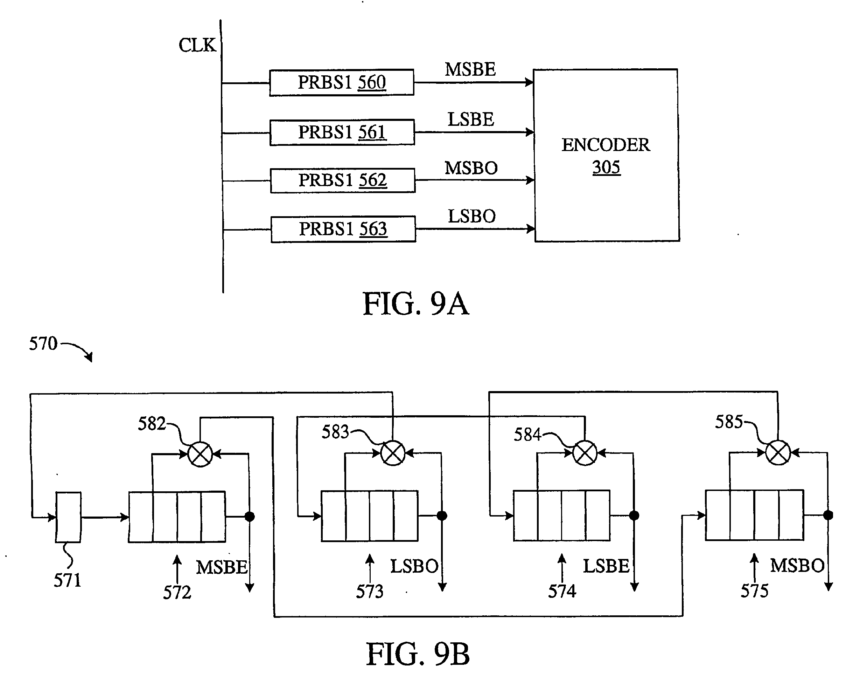

FIG. 9A shows a set of four PRBS generators 560-563 that can generate signals for testing the system of FIG. 8. The four PRBS generators 560-563 are identical but initialized or seeded with different bit settings, and may be used for example as PRBS generator(s) 530 of FIG. 8. A multiplexer, not shown in this figure, is provided to each of the bits to afford the choice of initializing the bit or running the PRBS. In this example, a first PRBS generator 560 is input as a MSBE signal to an encoder such as encoder 305, while a second PRBS generator 561 is input as a LSBE signal to encoder 305, a third PRBS generator 562 is input as a MSBO signal to encoder 305, and a fourth PRBS generator 563 is input as a LSBO signal to encoder 305.

FIG. 9B shows a single PRBS generator 570 that can generate a set of four signals (MSBE, LSBO, LSBE and MMSBO) that can be input to an encoder, not shown in this figure, for testing the system of FIG. 8. PRBS generator 570 may be used for example as PRBS generator(s) 530 of FIG. 8. PRBS generator 570 has a first flip-flop 571, followed by four sets of four flip-flops 572-575, configured with exclusive-OR gates 582-585 as shown. Other PRBS generators known in the art may be used in place of those shown in FIG. 9A and FIG. 9B.

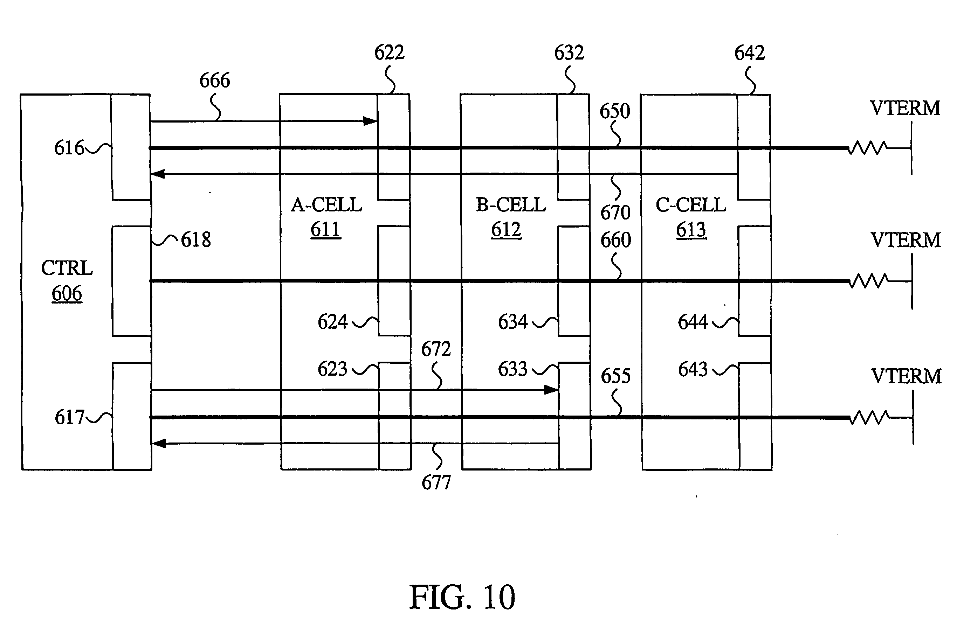

FIG. 10 shows a system 600 including a number of signal interfaces with built-in self-test mechanisms. The system 600 includes a control device CTRL 606 which may act as master to a number of other devices labeled A-CELL 611, B-CELL 612 and C-CELL 613. The control device CTRL 606 has first and second multilevel signal interfaces 616 and 617, as well as a binary or 2-PAM signal interface 618. Each of the signal interfaces may be a byte wide, similar to that described above with regard to FIG. 8. Likewise, A-CELL 611 has first and second multilevel signal interfaces 622 and 623, as well as a binary or 2-PAM signal interface 624, each of which may be a byte wide. Similarly, B-CELL 612 has first and second multilevel signal interfaces 632 and 633, as well as a binary signal interface 634, and C-CELL 613 has first and second multilevel signal interfaces 642 and 643, as well as a binary signal interface 644, each of which may be a byte wide.

Multilevel signal interfaces 616, 622, 632 and 642 are coupled to a first signal pathway such as bus 650, which may be a byte wide. Likewise, multilevel signal interfaces 617, 623, 633 and 643 are coupled to a second signal pathway such as bus 655, which may also be a byte wide. Similarly, binary signal interfaces 618, 624, 634 and 644 are coupled to a third signal pathway such as bus 660, which may also be a byte wide. Buses 650, 655 and 660 are terminated at VTERM with a matched impedance to reduce reflections.

Each of the devices 606 and 611-613 may have a test signal generator such as a PRBS generator and an error detector. In this case, receive mechanisms of devices 611-613 can be tested by sending signals from control device CTRL 606, and transmit mechanisms of devices 611-613 can be tested by sending signals sent to control device CTRL 606. Alternatively, only control device CTRL 606 may have a PRBS generator and error detector, with devices 611-613 being tested by sending signals to receive mechanisms of devices 611-613, with corresponding transmit mechanisms of those devices 611-613 sending signals back to control device CTRL 606 for error detection. Optionally, each of the signal interfaces 616-618, 622-624, 632-634 and 642-644 may be coupled to at least one test signal generator and error detector, and each interface unit of each of the signal interfaces 616-618, 622-624, 632-634 and 642-644 may be connected to a test signal generator. The choice of how many test mechanisms to employ along with each device may involve tradeoffs between the cost of the test mechanisms, such as space required by the test mechanisms, and the ease and exactness of the testing.

As an example, to test the receive mechanisms of multilevel signal interface 622, multilevel signal interface 616 may be caused by a PRBS generator to send a series of test signals along bus 650 to interface 622, as shown by arrow 666. Assuming that interface 622 has at least one PRBS detector, which may include a combination of PRBS generator and error detector, the PRBS detector can check whether the bus 650 and receive mechanism of signal interface 622 correctly received the signals. For the case in which a PRBS generator is provided for each interface unit of signal interface 616, and a PRBS detector is provided for each interface unit of signal interface 622, the receive mechanisms of signal interface 622 and the bus 650 can also be tested for errors caused by cross-talk, for example along bus 650.

To test the transmit mechanisms of multilevel signal interface 642, that interface may be caused by a PRBS generator to send a series of test signals along bus 650 to multilevel signal interface 616, as shown by arrow 670. A PRBS detector connected to interface 616 can check whether the bus 650 and transmit mechanism of signal interface 642 correctly sent the signals. For the case in which a PRBS generator is provided for each interface unit of signal interface 642, and a PRBS detector is provided for each interface unit of signal interface 616, the transmit mechanisms of signal interface 642 and the bus 650 can be tested for cross-talk conditions as well.

To test multilevel signal interface 633, a series of test signals are sent by multilevel signal interface 617 along bus 655 to a receive mechanism of interface 634, as shown by arrow 672. Assuming that the receive mechanism of interface 633 is not coupled to a PRBS detector but instead to a memory and transmit mechanism of that interface 633, the transmit mechanism can later send back a series of signals along bus 655 to a receive mechanism of interface 617, as shown by arrow 677. A PRBS detector connected to interface 617 can check whether the bus 655 and receive and transmit mechanisms of signal interface 634 correctly relayed the signals over bus 655. For the case in which a PRBS generator is provided for each interface unit of signal interface 617, the receive and transmit mechanisms of signal interface 633 and the bus 655 can be tested for cross-talk conditions as well.

For example, control device CTRL 606 can transmit PRBS sequences through interface 616 to interface 632, filling some or all of the addresses of a memory on B-CELL 612. B-CELL 612 is then instructed to transmit all of the PRBS data from its memory, the PRBS data being received by interface 616. Control device CTRL 606 can then check the data with a PRBS error detector.

Buses 650, 655 and 660 may be memory buses or other buses internal to an apparatus such as a computer and may, for example, be affixed to a base such as a PCB or may be part of an IC that is affixed to a base such as a wafer substrate. Alternatively, buses 650, 655 and 660 may connect peripheral devices with a computer, so that control device CTRL 606 may be representative of the computer and A-CELL 611, B-CELL 612 and C-CELL 613 may be representative of peripheral devices such as disk drives. As another example, buses 650, 655 and 660 may represent networks connecting control device CTRL 606, A-CELL 611, B-CELL 612 and C-CELL 613. Further, although it may function as a master device, control device CTRL 606 may be substantially identical to A-CELL 611, B-CELL 612 and/or C-CELL 613. Control device CTRL 606 may also transmit master clock signals along buses 650, 655 and 660 to synchronize various elements of A-CELL 611, B-CELL 612 and C-CELL 613.

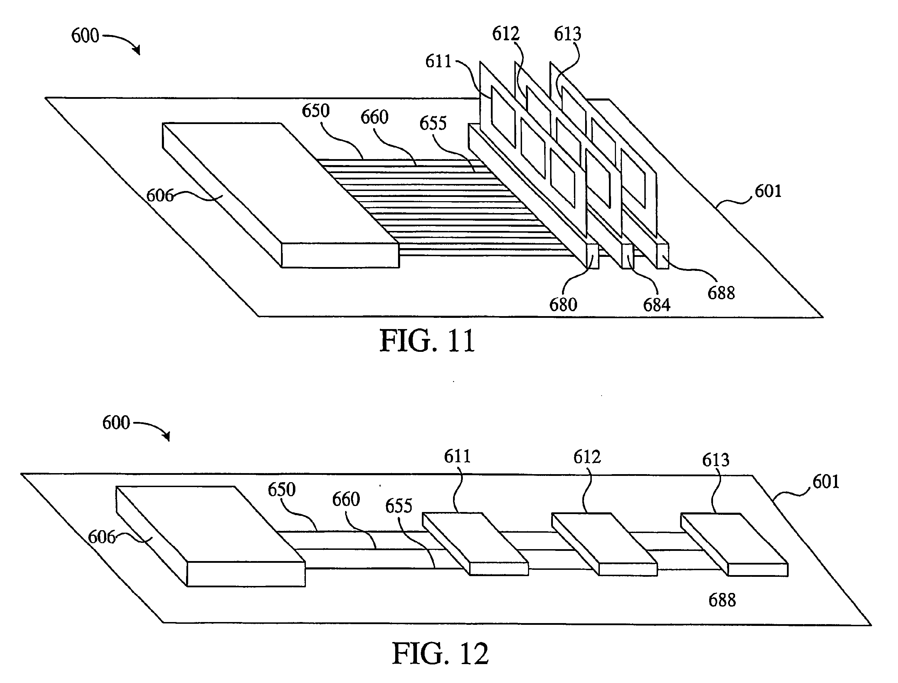

FIG. 11 shows an implementation in which system 600 comprises a highspeed memory system, with control device CTRL 606 representing a controller and A-CELL 611, B-CELL 612 and C-CELL 613 representing memory cells. The system 600 includes a base such as a PCB 601 (sometimes called a motherboard) to which a memory controller 606, signaling paths 650, 655 and 660, and connectors 680, 684 and 688 are affixed. Memory modules 690, 694, and 698, each containing one or more memory devices 611, 612 and 613, are affixed to the printed circuit board 601 by being removably inserted into the connectors 680, 684 and 688. Though not shown in FIG. 11, the memory modules 690, 694, and 698 include traces to couple the memory devices 611, 612 and 613 to the signaling paths 650, 655 and 660, and ultimately to the memory controller 606.

In the embodiment of FIG. 11FIG. 11, the signaling paths 650, 655 and 660 constitute multi-drop buses that are coupled to each memory module 690, 694, and 698. The individual memory devices of a given module may be coupled to the same set of signaling lines within signaling paths 650, 655 and 660, or each memory device of the module may be coupled to a respective subset of the signaling lines. In the latter case, two or more memory devices on a module may be accessed simultaneously to read or write a data value that is wider (i.e., contains more bits) than the data interface of a single memory device. In an alternative embodiment (not shown), each of the memory modules may be coupled to the memory controller via a dedicated signaling path (i.e., a point-to-point connection rather than a multi-drop bus). In such an embodiment, each of the memory devices on the memory module may be coupled to a shared set of signaling lines of the dedicated path, or each memory device may be coupled to respective subsets of the signaling lines.

The signaling paths 650, 655 and 660 may include multiplexed sets of signal lines to transfer both data and control information between the memory controller 606 and memory devices 611, 612 and 613. Alternatively, as described regarding FIG. 10, the signaling paths 650 and 660 may be employed for transferring data between the memory devices 611, 612 and 613 and the memory controller 60, and signaling paths 655 may be employed for transferring timing and control information between the memory devices 611, 612 and 613 and the memory controller 603 (e.g., clock signals, read/write commands, and address information). Also, the timing information may be generated within the memory controller 606, or by external circuitry (not shown).

While a memory system that includes connectors for removable insertion of memory modules is depicted in FIG. 11, other system topologies may be used. As shown in FIG. 12, the memory devices 611, 612 and 613 need not be disposed on memory modules, but rather may be individually coupled to the printed circuit board 601. A connectorless interface such as that illustrated in FIG. 12 may be preferable for multi-level signaling, because connectors add reflected noise and attenuation to the channels.

Alternatively, the memory devices, the memory controller and the signaling path may all be included within a single integrated circuit along with other circuitry (e.g., graphics control circuitry, digital signal processing circuitry, general purpose processing circuitry, etc.). Such a system or that shown in FIG. 11 or FIG: 12 can be used in various electronic or optical devices, including computer systems, telephones, network devices (e.g., switch, router, interface card, etc.), handheld electronic devices and intelligent appliances.

Although we have focused on teaching the preferred embodiments of testing, with built-in test mechanisms, devices including a multilevel signal interfaces, other embodiments and modifications of this invention will be apparent to persons of ordinary skill in the art in view of these teachings. Therefore, this invention is limited only by the following claims.

## Claims

1. A device (300) for multi-PAM signal data transfer **characterized by**:
a signal generator (355) adapted to generate binary test signals (358), and
multi-PAM signal interface components comprising:
a transmit mechanism (305, 310) operably coupled to said signal generator (355) and adapted to output a first multi-PAM signal based on said binary test signals (358),
a receive mechanism (315, 320) operably coupled to said transmit mechanism (305, 310) and adapted to detect a second multi-PAM signal based on said first multi-PAM signal said receive mechanism (315, 320) outputting a binary detected signal (364) based on said second multi-PAM signal, the device (300) further comprising
an error detection mechanism (360) operably coupled to said receive mechanism (315, 320) and adapted to compare said binary detected signal (364) with a binary reference signal (366, 377), and to output an error signal if said detected signal (364) does not match said binary reference signal (366, 377).

2. The device of claim 1, wherein said transmit mechanism (305, 310) is part of a first multi-PAM signal interface unit (410), said receive mechanism (315, 320) is part of a second multi-PAM signal interface unit (420), said first multi-PAM signal interface unit (410) includes a first receive mechanism (416) and said second signal interface unit (420) includes a second transmit mechanism (424).

3. The device of claim 2, further comprising a third multi-PAM interface unit (430) having a third transmit mechanism (434) and a third receive mechanism (436), wherein said third transmit mechanism (434) is operably coupled to said second receive mechanism (426).

4. The device of claim 1, 2 or 3, wherein said transmit mechanism (404) includes a plurality of transmitters (414, 424, 434) and said receive mechanism includes a plurality of receivers (416, 426, 436), with each of said transmitters (414, 424, 434) being operably coupled to a corresponding one of said receivers (416, 426, 436).

5. The device of claim 1 comprising:
a master element (606) including a controller and a master multi-PAM signal interface (616, 617) containing the transmit mechanism and the receive mechanism, said master being coupled to a signal pathway, the device comprising further
a plurality of slave elements (611-613) each including a slave multi-PAM signal interface (622, 623, 632, 633, 642, 643) containing the transmit mechanism and a receive mechanism, and being coupled to said signal pathway, and the error detection mechanism being coupled to at least one of said signal interfaces wherein a plurality of multi-PAM signals are communicated between said master multi-PAM signal interface and at least one of said slave multi-PAM signal interfaces over said signal pathway and
the multi-PAM signal interfaces (616, 617, 622, 623, 632, 633, 642, 643) is checked by said error detection mechanism (360, 444, 535) for errors.

6. The device of claim 5, wherein said error detection mechanism (360) is coupled to said one slave signal interface (622, 623, 632, 633, 642, 643) and said multi-PAM signals are sent from said master (606) transmit mechanism to said receive mechanism of said one slave multi-PAM signal interface (622, 623, 632, 633, 642, 643).

7. The device of claim 5, wherein said error detection mechanism is coupled to said master multi-PAM signal interface (616, 617) and said multi-PAM signals are sent from said one slave transmit mechanism to said master receive mechanism.

8. The device of claim 5, wherein said error detection mechanism (360, 444, 535) is coupled to said master multi-PAM signal interface (616, 617), said signals are sent from said master transmit mechanism to said receive mechanism of said one slave multi-PAM signal interface (622, 623, 632, 633, 642, 643), and said signals are sent from said transmit mechanism of said one slave multi-PAM signal interface (622, 623, 632, 633, 642, 643) to said master receive mechanism.

9. The device of claim 1, wherein the transmit mechanism and said receive mechanism are part of a signal interface unit (616, 617, 622-624, 632-634, 642-644) including an input/output pin connected to said second conductive path (655).

10. The device of claim 1, wherein said transmit mechanism is part of a first signal interface unit (616, 617, 622-624, 632-634, 642-644), said receive mechanism is part of a second signal interface unit (616, 617, 622-624, 632-634, 642-644), said first signal interface unit (616, 617, 622-624, 632-634, 642-644) includes a second receive mechanism and said second signal interface unit (616, 617, 622-624, 632-634, 642-644) includes a second transmit mechanism.

11. A method for testing a multi-PAM signal interface (330), the method being **characterized by**:
transmitting to the signal interface (330), a first sequence of binary signals,
converting, by the signal interface (330), said first sequence of binary signals into a first sequence of multi-PAM signals,
transmitting by the multi-PAM signal interface (330) said first sequence of multi-PAM signals,
receiving by the multi-PAM signal interface (330) a second sequence of multi-PAM signals based on said first sequence of multi-PAM signals,
converting, by the multi-PAM signal interface (330), said second sequence of multi-PAM signals into a second sequence of binary signals,
comparing, said second sequence of binary signals with said first sequence of binary signals.

12. The method of claim 11, further comprising delaying, said first sequence of binary signals for comparing with said second sequence of binary signals.

13. The method of claim 11 wherein the multi-PAM signal interface (404) comprises a first set of signal interface units and a second set of signal interface units, and each signal interface unit (410) of said first set is connected to one signal interface unit (420) of said second set, wherein:
the receiving step comprises receiving, by said first set (410), a first sequence of binary signals,
the first converting step comprises converting, by the multi-PAM signal interface (404), said first sequence of binary signals into a sequence of multi-PAM signals,
the transmitting step comprises transmitting, from a signal interface unit (410) of said first set to a signal interface unit (420) of said second set, said sequence of multi-PAM signals,
the second converting step comprises converting, by the multi-PAM signal interface (404), said sequence of multi-PAM signals into a second sequence of binary signals, and
the comparing step comprises comparing, said second sequence of binary signals with said first sequence of binary signals.

## Patentansprüche

1. Vorrichtung (300) für die Multi-PAM-Signaldatenübertragung, **gekennzeichnet durch**:
einen Signalgenerator (355), welcher ausgestaltet ist, um binäre Testsignale (358) zu erzeugen, und
Multi-PAM-Schnittstellenkomponenten, welche umfasst:
einen Sendemechanismus (305, 310), welcher funktionsgemäß mit dem Signalgenerator (355) gekoppelt ist und ausgestaltet ist, um ein erstes Multi-PAM-Signal basierend auf den binären Testsignalen (358) auszugeben,
einen Empfangsmechanismus (315, 320), welcher mit dem Sendemechanismus (305, 310) funktionsgemäß gekoppelt ist und ausgestaltet ist, um ein zweites Multi-PAM-Signal zu detektieren, basierend auf dem ersten Multi-PAM-Signal, wobei der Empfangsmechanismus (315, 320) ein binäres Detektionssignal basierend auf dem zweiten Multi-PAM-Signal (364) ausgibt, und wobei die Vorrichtung (300) weiter umfasst
einen Fehlerdetektionsmechanismus (360), welcher mit dem Empfangsmechanismus (315, 320) funktionsgemäß gekoppelt ist und ausgestaltet ist, um das binäre Detektionssignal (364) mit einem binären Referenzsignal (366, 377) zu vergleichen und ein Fehlersignal auszugeben, wenn das Detektionssignal (364) nicht mit dem binären Referenzsignal (366, 377) übereinstimmt.

2. Vorrichtung nach Anspruch 1, wobei der Sendemechanismus (305, 310) Teil einer ersten Multi-PAM-Signalschnittstelleneinheit (410) ist, der Empfangsmechanismus (315, 320) Teil einer zweiten Multi-PAM-Signalschnittstelleneinheit (420) ist, die erste Multi-PAM-Signalschnittstelleneinheit (410) einen ersten Empfangsmechanismus (416) beinhaltet und die zweite Schnittstelleneinheit (420) einen zweiten Sendemechanismus (424) beinhaltet.

3. Vorrichtung nach Anspruch 2, weiter umfassend eine dritte Multi-PAM-Schnittstelleneinheit (430), welche einen dritten Sendemechanismus (434) und einen dritten Empfangsmechanismus (436) aufweist, wobei der dritte Sendemechanismus (434) funktionsgemäß mit dem zweiten Empfangsmechanismus (426) gekoppelt ist.

4. Vorrichtung nach Anspruch 1, 2 oder 3, wobei der Sendemechanismus (404) eine Mehrzahl von Sendern (414, 424, 434) beinhaltet und der Empfangsmechanismus eine Mehrzahl von Empfängern (416, 426, 436) beinhaltet, wobei jeder der Sender (414, 424, 434) funktionsgemäß mit einem korrespondierenden Empfänger der Empfänger (416, 426, 436) gekoppelt ist.

5. Vorrichtung nach Anspruch 1, umfassend:
eine Masterkomponente (606), welche einen Controller und eine Master-Multi-PAM-Signalschnittstelle (616, 617) beinhaltet, welche den Sendemechanismus und den Empfangsmechanismus enthält, wobei der Master mit einem Signalpfad gekoppelt ist und die Vorrichtung weiter umfasst:
eine Mehrzahl von Slavekomponenten (611-613), von denen jede eine Slave-Multi-PAM-Signalschnittstelle (622, 623, 632, 633, 642, 643) beinhaltet, welche den Sendemechanismus und einen Empfangsmechanismus enthält und mit dem Signalpfad gekoppelt ist und dem Fehlerdetektionsmechanismus, welcher mit mindestens einer der Signalschnittstellen gekoppelt ist, wobei eine Mehrzahl von Multi-PAM-Signalen zwischen der Master-Multi-PAM-Signalschnittstelle und mindestens einer der Slave-Multi-PAM-Signalschnittstellen über den Signalpfad kommuniziert wird und
die Multi-PAM-Signalschnittstelle (616, 617, 622, 623, 632, 633, 642, 643) von dem Fehlerdetektionsmechanismus (360, 444, 535) auf Fehler geprüft wird.

6. Vorrichtung nach Anspruch 5, wobei der Fehlerdetektionsmechanismus (360) mit der einen Slavesignalschnittstelle (622, 623, 632, 633, 642, 643) gekoppelt ist und die Multi-PAM-Signale von dem Master (606)-Sendemechanismus zu dem Empfangsmechanismus der einen Slave-Multi-PAM-Signalschnittstelle (622, 623, 632, 633, 642, 643) gesendet werden.

7. Vorrichtung nach Anspruch 5, wobei der Fehlerdetektionsmechanismus mit der Master-Multi-PAM-Signalschnittstelle (616, 617) gekoppelt ist und die Multi-PAM-Signale von dem einen Slave-Sendemechanismus zu dem Master-Empfangsmechanismus gesendet werden.

8. Vorrichtung nach Anspruch 5, wobei der Fehlerdetektionsmechanismus (360, 444, 535) mit der Master-Multi-PAM-Signalschnittstelle (616, 617) gekoppelt ist, die Signale von dem Mastersendemechanismus zu dem Empfangsmechanismus der einen Slave-Multi-PAM-Signalschnittstelle (622, 623, 632, 633, 642, 643) gesendet werden und die Signale von dem Sendemechanismus der einen Slave-Multi-PAM-Signalschnittstelle (622, 623, 632, 633, 642, 643) zu dem Master-Empfangsmechanismus gesendet werden.

9. Vorrichtung nach Anspruch 1, wobei der Sendemechanismus und der Empfangsmechanismus Teil einer Signalschnittstelleneinheit (616, 617, 622-624, 632-634, 642-644) sind, welche einen Eingabe-/Ausgabepin beinhaltet, welcher an den zweiten leitfähigen Pfad (655) angeschlossen ist.

10. Vorrichtung nach Anspruch 1, wobei der Sendemechanismus Teil einer ersten Signalschnittstelleneinheit (616, 617, 622-624, 642-644) ist, der Empfangsmechanismus Teil einer zweiten Signalschnittstelleneinheit (616, 617, 622-624, 632-634, 642-644) ist, die erste Signalschnittstelleneinheit (616, 617, 622-624, 632-634, 642-644) einen zweiten Empfangsmechanismus beinhaltet und die zweite Signalschnittstelleneinheit (616, 617, 622-624, 632-634, 642-644) einen zweiten Sendemechanismus beinhaltet.

11. Verfahren zum Testen einer Multi-PAM-Signalschnittstelle (330), wobei das Verfahren **gekennzeichnet ist durch**:
Senden einer ersten Sequenz von Binärsignalen an die Signalschnittstelle (330),
Umwandeln der ersten Sequenz von Binärsignalen in eine zweite Sequenz von Multi-PAM-Signalen **durch** die Signalschnittstelle (330),
Übertragen der ersten Sequenz von Multi-PAM-Signalen **durch** die Multi-PAM-Signalschnittstelle (330),
Empfangen einer zweiten Sequenz von Multi-PAM-Signalen basierend auf der ersten Sequenz von Multi-PAM-Signalen **durch** die Multi-PAM-Signalschnittstelle (330),
Umwandeln der zweiten Sequenz von Multi-PAM-Signalen in eine zweite Sequenz von Binärsignalen **durch** die Multi-PAM-Signalschnittstelle (330),
Vergleichen der zweiten Sequenz von Binärsignalen mit der ersten Sequenz von Binärsignalen.

12. Verfahren nach Anspruch 11, welches weiter ein Verzögern der ersten Sequenz von Binärsignalen für das Vergleichen mit der zweiten Sequenz von Binärsignalen umfasst.

13. Verfahren nach Anspruch 11, wobei die Multi-PAM-Signalschnittstelle (404) ein erstes Set von Signalschnittstelleneinheiten und ein zweites Set von Signalschnittstelleneinheiten umfasst, und jede Signalschnittstelleneinheit (410) des ersten Sets an eine Signalschnittstelleneinheit (420) des zweiten Sets angeschlossen ist, wobei:
der Schritt des Empfangens umfasst: Empfangen einer ersten Sequenz von Binärsignalen durch das erste Set (410),
der erste Schritt des Umwandelns umfasst: Umwandeln der ersten Sequenz von Binärsignalen in eine zweite Sequenz von Multi-PAM-Signalen durch die Multi-PAM-Signalschnittstelle (404),
der Schritt des Sendens umfasst: Senden der Sequenz von Multi-PAM-Signalen von der ersten Signalschnittstelleneinheit (410) des ersten Sets zu einer Signalschnittstelleneinheit (420) des zweiten Sets,
der zweite Schritt des Umwandelns umfasst: Umwandeln der ersten Sequenz von Multi-PAM-Signalen in eine zweite Sequenz von Binärsignalen durch die Multi-PAM-Signalschnittstelle (404), und
der Schritt des Vergleichens umfasst: Vergleichen der zweiten Sequenz von Binärsignalen mit der ersten Sequenz von Binärsignalen.

## Revendications

1. Dispositif (300) pour le transfert de données de signaux multi-PAM **caractérisé par** :
un générateur de signaux (355) adapté pour générer des signaux de tests binaires (358), et
des composants d'interface de signaux multi-PAM comprenant :
un mécanisme de transmission (305, 310) couplé de manière utilisable au dit générateur de signaux (355) et adapté pour délivrer un premier signal multi-PAM sur la base desdits signaux de tests binaires (358),
un mécanisme de réception (315, 320) couplé de manière utilisable au dit mécanisme de transmission (305, 310) et adapté pour détecter un deuxième signal multi-PAM sur la base dudit premier signal multi-PAM, ledit mécanisme de réception (315, 320) délivrant un signal détecté binaire (364) sur la base dudit deuxième signal multi-PAM, le dispositif (300) comprenant en outre :
un mécanisme de détection d'erreur (360) couplé de manière utilisable au dit mécanisme de réception (315, 320) et adapté pour comparer ledit signal détecté binaire (364) à un signal de référence binaire (366, 377), et pour délivrer un signal d'erreur si ledit signal détecté (364) ne correspond pas au dit signal de référence binaire (366, 377).

2. Dispositif selon la revendication 1, dans lequel ledit mécanisme de transmission (305, 310) fait partie d'une première unité d'interface de signaux multi-PAM (410), ledit mécanisme de réception (315, 320) fait partie d'une deuxième unité d'interface de signaux multi-PAM (420), ladite première unité d'interface de signaux multi-PAM (410) comprend un premier mécanisme de réception (416) et ladite deuxième unité d'interface de signaux (420) comprend un deuxième mécanisme de transmission (424).

3. Dispositif selon la revendication 2, comprenant en outre une troisième unité d'interface multi-PAM (430) ayant un troisième mécanisme de transmission (434) et un troisième mécanisme de réception (436), dans lequel ledit troisième mécanisme de transmission (434) est couplé de manière utilisable au dit deuxième mécanisme de réception (426).

4. Dispositif selon la revendication 1, 2 ou 3, dans lequel ledit mécanisme de transmission (404) comprend une pluralité d'émetteurs (414, 424, 434) et ledit mécanisme de réception comprend une pluralité de récepteurs (416, 426, 436), chacun desdits émetteurs (414, 424, 434) étant couplé de manière utilisable à l'un correspondant desdits récepteurs (416, 426, 436).

5. Dispositif selon la revendication 1, comprenant en outre :
un élément maître (606) comprenant un contrôleur et une interface de signaux multi-PAM maître (616, 617) contenant le mécanisme de transmission et le mécanisme de réception, ledit maître étant couplé à un chemin de signaux, le dispositif comprenant en outre :
une pluralité d'éléments esclaves (611 à 613) comprenant chacun une interface de signaux multi-PAM esclave (622, 623, 632, 633, 642, 643) contenant le mécanisme de transmission et un mécanisme de réception, et étant couplée au dit chemin de signaux, et le mécanisme de détection d'erreur étant couplé à au moins l'une desdites interface de signaux dans lequel une pluralité de signaux multi-PAM sont communiqués entre ladite interface de signaux multi-PAM maître et au moins l'une desdites interfaces de signaux multi-PAM esclaves sur ledit chemin de signaux et
les interfaces de signaux multi-PAM (616, 617, 622, 623, 632, 633, 642, 643) sont contrôlées par ledit mécanisme de détection d'erreur (360, 444, 535) à la recherche d'erreurs.

6. Dispositif selon la revendication 5, dans lequel ledit mécanisme de détection d'erreur (360) est couplé à ladite une interface de signaux esclave (622, 623, 632, 633, 642, 643) et lesdits signaux multi-PAM sont envoyés dudit mécanisme de transmission maître (606) au dit mécanisme de réception de ladite une interface de signaux multi-PAM esclave (622, 623, 632, 633, 642, 643).

7. Dispositif selon la revendication 5, dans lequel ledit mécanisme de détection d'erreur est couplé à ladite interface de signaux multi-PAM maître (616, 617) et lesdits signaux multi-PAM sont envoyés dudit un mécanisme de transmission esclave au dit mécanisme de réception maître.

8. Dispositif selon la revendication 5, dans lequel ledit mécanisme de détection d'erreur (360, 444, 535) est couplé à ladite interface de signaux multi-PAM maître (616, 617), lesdits signaux sont envoyés dudit mécanisme de transmission maître au dit mécanisme de réception de ladite une interface de signaux multi-PAM esclave (622, 623, 632, 633, 642, 643), et lesdits signaux sont envoyés dudit mécanisme de transmission de ladite une interface de signaux multi-PAM esclave (622, 623, 632, 633, 642, 643) au dit mécanisme de réception maître.

9. Dispositif selon la revendication 1, dans lequel le mécanisme de transmission et ledit mécanisme de réception font partie d'une unité d'interface de signaux (616, 617, 622 à 624, 632 à 634, 642 à 644) comprenant une broche d'entrée/sortie connectée au dit deuxième chemin conducteur (655).

10. Dispositif selon la revendication 1, dans lequel ledit mécanisme de transmission fait partie d'une première unité d'interface de signaux (616, 617, 622 à 624, 632 à 634, 642 à 644), ledit mécanisme de réception fait partie d'une deuxième unité d'interface de signaux (616, 617, 622 à 624, 632 à 634, 642 à 644), ladite première unité d'interface de signaux (616, 617, 622 à 624, 632 à 634, 642 à 644) comprend un deuxième mécanisme de réception et ladite deuxième unité d'interface de signaux (616, 617, 622 à 624, 632 à 634, 642 à 644) comprend un deuxième mécanisme de transmission.

11. Procédé pour tester une interface de signaux multi-PAM (330), le procédé étant **caractérisé par** :
la transmission à l'interface de signaux (330) d'une première séquence de signaux binaires,
la conversion par l'interface de signaux (330) de ladite première séquence de signaux binaires en une première séquence de signaux multi-PAM,
la transmission par l'interface de signaux multi-PAM (330) de ladite première séquence de signaux multi-PAM, la réception par l'interface de signaux multi-PAM (330) d'une deuxième séquence de signaux multi-PAM sur la base de ladite première séquence de signaux multi-PAM,
la conversion par l'interface de signaux multi-PAM (330) de ladite deuxième séquence de signaux multi-PAM en une deuxième séquence de signaux binaires,
la comparaison de ladite deuxième séquence de signaux binaires à ladite première séquence de signaux binaires.

12. Procédé selon la revendication 11, comprenant en outre l'étape consistant à retarder ladite première séquence de signaux binaires pour la comparer à ladite deuxième séquence de signaux binaires.

13. Procédé selon la revendication 11, dans lequel l'interface de signaux multi-PAM (404) comprend un premier ensemble d'unités d'interface de signaux et un deuxième ensemble d'unités d'interface de signaux, et chaque unité d'interface de signaux (410) dudit premier ensemble est connectée à une unité d'interface de signaux (420) dudit deuxième ensemble, dans lequel :
l'étape de réception comprend la réception par ledit premier ensemble (410) d'une première séquence de signaux binaires,
la première étape de conversion comprend la conversion par l'interface de signaux multi-PAM (404) de ladite première séquence de signaux binaires en une séquence de signaux multi-PAM,
l'étape de transmission comprend la transmission d'une unité d'interface de signaux (410) dudit premier ensemble à une unité d'interface de signaux (420) dudit deuxième ensemble, de ladite séquence de signaux multi-PAM,
la deuxième étape de conversion comprend la conversion par l'interface de signaux multi-PAM (404) de ladite séquence de signaux multi-PAM en une deuxième séquence de signaux binaires, et
l'étape de comparaison comprend la comparaison de ladite deuxième séquence de signaux binaires à ladite première séquence de signaux binaires.
